# EUROPEAN PATENT SPECIFICATION

(11) **EP 2 728 490 B1**
(45) Date of publication and mention of the grant of the patent: **12.07.2017**
(21) Application number: 12190823.0
(22) Date of filing: 31.10.2012
(51) Int. Cl.: H04L 12/24, G06F 17/50, G06F 15/173

(54) **Application execution method in computing**
Anwendungsausführungsverfahren beim Rechnen
Procédé d'exécution d'application dans un calcul

(43) Date of publication of application: 07.05.2014
(73) Proprietor: FUJITSU LIMITED, Kawasaki-shi, Kanagawa 211-8588 (JP)
(72) Inventor: Saksena, Radhika, London, W3 6SP (GB)
(74) Representative: Hutchison, James

(56) References cited:
- EP-A2- 1 282 038
- US-A1- 2008 092 146
- US-A1- 2009 016 332
- RAMAMRITHAM K ET AL: "O(N) SCHEDULING ALGORITHMS FOR REAL-TIME MULTIPROCESSOR SYSTEMS", ALGORITHMS AND APPLICATIONS. PENNSYLVANIA, AUG. 8 - 12, 1989; [PROCEEDINGS OF THE INTERNATIONAL CONFERENCE ON PARALLEL PROCESSING], NEW YORK, IEEE, US, vol. 3, 8 August 1989 (1989-08-08), pages III143-152, XP000078442,

## Description

The present invention lies in the field of computing, and in particular relates to executing an application on computing apparatuses which include networked computing nodes.

Multi-core architectures are now becoming dominant in high performance computing, so that each processor in a computing apparatus is able to perform more than one processing thread simultaneously. Applications intended to run on such computing apparatuses are tuned to take full advantage of the increases in processing speed brought about by the ability to process multiple threads of instructions simultaneously. Likewise, the computing apparatuses are tuned to allocate computational tasks to groups of resources within the computing apparatus in a way which takes into account the specific requirements of the application and its tasks.

Applications include computational tasks which are performed by a processor in order to generate results, which may then be used in subsequent processing tasks and so on. However, applications also include communication tasks, which require nodes within a computing apparatus to communicate data to one another. As the architecture of multi-node computing apparatuses becomes more complex, the process of performing modelling and simulation to find the best way of performing communication tasks becomes correspondingly more complex.

US patent publication US2009/0016332A1 discloses a node architecture in which the data exchanges can be executed simultaneously in two directions, which allows data exchanges to be performed within adjacent areas in a user program for simulation of natural phenomena.

Embodiments of the present invention include a method for executing an application in a computing apparatus having a plurality of computing nodes arranged in an n-dimensional network, where n is an integer greater than or equal to 1, each computing node being configured to perform a plurality of processing threads simultaneously, and each computing node being connected to each of their neighbouring nodes via separate, possibly parallel, data communication links, each computing node having a plurality of communication engines operable, simultaneously, and enlisting different combinations of data communication links from one another, to communicate a stream of data to one or more destination nodes; the method comprising: executing the application at a particular computing node from among the plurality of computing nodes; including: detecting that a communication task, including communicating data from the particular computing node to one or more destination computing nodes from among the plurality of computing nodes, is to be executed; and selecting, in dependence upon a benchmarking process, a configuration of communication engines and processing threads per communication engine to allocate to executing the detected communication task.

With increasing dominance of multi-core architectures in high performance computing, the optimal utilization of threads in multi-threaded HPC applications has become increasingly important in order to extract maximum performance. Technologies involved in optimizing multi-threaded performance, usually, focus only on computational tasks. But the issue of thread utilisation is also encountered if the communication task is thread-parallelized. Embodiments of the present invention exploit the potential for thread parallelization of communication tasks in those multi-threaded HPC applications which can take advantage of multi-dimensional network topologies, such as hyper-dimensional network topologies. Throughout this document we include in the phrase "multi-dimensional network" any network from 1-dimensional networks (simple ring) up to complex hyper-dimensional networks. These applications can take advantage of parallel communication which is made possible by the presence of multiple communication links per node such as in the case of Fujitsu's Tofu network topology. We note that, where "separate data communication links" are mentioned, it includes the possibility that two computing nodes are linked by two or more parallel data communication links, which may be treated as multiple independent data communication links. Therefore, "separate" when used to refer to links between nodes, may be interpreted as "separate, possibly parallel".

Embodiments of the present invention provide a framework for the dynamic selection of a thread and communication engine configuration according to the requirements of a particular communication task. The use of a benchmarking process enables network topology (e.g. maximum number of simultaneous communication engines available), network architecture (e.g. symmetric or asymmetric torus), communication primitive characteristics and message characteristics to be taken into account in the selection of a configuration, without requiring complex simulation models to be run. Of course, the benchmarking process may be such that it preserves the communication primitive characteristics and message characteristics from the actual data communication task.

Certain applications can take advantage of multi-dimensional network topologies and the presence of multiple communication links (correspondingly driven by multiple communication engines) per node. Embodiments of the present invention enable the computing node(s) running such an application to make a decision on whether some or all of the available communication engines at a node should be utilised to complete a communication task. For example, depending on the message size and the communication pattern (point-to-point, or all-to-all), the overhead of dividing the communication task among multiple communication engines and then among multiple processing threads may outweigh the benefits of parallelisation. In such cases, it may be optimal to use less than the maximum number of communication engines that are available. Furthermore, the number of processing threads which should be used per communication engine will depend on factors such as the number and type of communication links that are available to each node and the characteristics of the communication task. For example, for distributed applications running on asymmetric network topologies, it is possible to decompose and pipeline communicating a stream of data such that different sub-tasks of communicating the stream of data are assigned to separate simultaneous processing threads on a node. Examples of such sub-tasks include packing/unpacking buffers and sending/receiving data. The number of threads to enlist to ensure desired performance is a matter of careful tuning. The use of a benchmarking process to select a configuration of numbers of communication engines and processing threads per communication engine ensures that factors such as the message size, communication pattern, and overheads of dividing a task up, and the interaction of such factors, are taken into account in selecting a configuration of numbers of communication engines and threads per communication engine.

Selections of numbers of communication engines and processing threads per communication engine are difficult to make manually by end users for individual applications with different characteristics and running on different types of multi-dimensional and asymmetric network topologies. Embodiments of the present invention provide a framework and automated method of generating an ideal configuration (auto-tuning) of communication engine- and thread-parallelism for communication tasks in dependence upon runtime benchmark performance.

A multi-dimensional network of computing nodes may be a plurality of computing nodes connected in a hyper-dimensional network architecture, wherein each computing node may have a processor, memory, and ports for communication with connected computing nodes. Each computing node may comprise one or more multi-core processor, and other hardware may be shared between more than one core and/or more than one processor. The computing nodes may be connected as an n-dimensional mesh (where n is greater than or equal to 1), or as an n-dimensional torus (where n is greater than or equal to 1), wherein either a mesh or a torus may be symmetric or asymmetric. Each computing node may have a physical connection to its two neighbours in each dimension (although in a mesh there will be end nodes which may only have a single neighbour in the dimension(s) for which they form the end of the mesh) over which data can be communicated, although the number of communication engines at the computing node may not equal the number of physical connections, so that the computing node is not able to simultaneously communicate streams of data over each connection. In that sense, a communication link may be considered to be a physical connection to neighbouring nodes over which data may be communicated. Alternatively, communication links may also be realised wirelessly. In certain embodiments, the communication links may be realised via optical connections between neighbouring nodes. One communication engine may be provided per communication link. A communication engine may be considered to be a functional entity which utilises certain hardware on a computing node to drive a communication link between two nodes, or to perform the processing required to instruct the transfer of data to a destination over one or a combination, or series, of communication links.

A configuration of communication engines and processing threads per communication engine may be identified communication engines and processing threads, however, it may be that the configuration is a number of communication engines and a number of processing threads per communication engine.

Selecting a configuration of communication engines and processing threads in dependence upon a benchmarking process is advantageous because it incorporates empirical assessment of the impact of factors such as network topology and network architecture, and other factors affecting data communication, on the actual data communication task to be performed (or more accurately on a benchmarking data communication task representing the communication task to be performed). Therefore a selection can be made in the light of actual data communication representative of the data communication task to be performed and in the same network topology and architecture in which the data communication task is to be performed. Selecting a configuration of communication engines and processing threads in dependence upon a benchmarking process includes selecting a configuration of communication engines in dependence upon the results of a benchmarking process. The results of a benchmarking process, may be, for example, a specification of an optimal configuration, or a set of performance indicators predicting how quickly each of a plurality of candidate configurations will perform the communication task to be performed. Such performance indicators may be derived based on performance statistics from the performance of a benchmarking communication task representing the communication task to be performed.

Selecting a configuration in dependence upon a benchmarking process may include applying a selection policy to the outcome of a benchmarking process to determine an optimal configuration to select. For example, the outcome of a benchmarking process may include performance indicators for each of a plurality of candidate configurations, which performance indicators are derived on the basis of performance statistics from performing a benchmarking communication task representative of the communication task to be performed but being smaller in terms of the amount of data. A metric could then be applied to the performance indicators in order to find an optimal configuration to select. The metric may be predetermined and may be as simple as finding the configuration which (on the basis of the benchmarking process) will complete the communication task in the shortest time.

That is to say, the benchmarking process may comprise composing a benchmarking communication task based on the communication task, performing the benchmarking communication task using each of a plurality of candidate configurations of numbers of communication engines and processing threads per communication engine; and gathering performance indicators for each of the candidate configurations. Optionally, the benchmarking process further comprises: identifying, from among the candidate configurations, an optimal configuration for executing the communication task based on the gathered performance indicators; and the method includes selecting the optimal configuration as the configuration of numbers of communication engines and processing threads per communication engine to allocate to executing said communication task.

In order to optimise performance of the computing apparatus, it may be that the method further comprises storing the gathered performance indicators in association with a characterisation of the communication task. Such storage would allow the performance indicators to be used in future when a similar communication task (similarity being based on the characterisation) is encountered, thus obviating the requirement to actually run the benchmarking communication tasks. As an extension of this option, embodiments may include storing a representation of the optimal configuration in association with a characterisation of the communication task. Hence, when an optimal configuration for performing a communication task has been determined by running/performing a benchmarking process, the configuration which was deemed to be optimal can be stored with a characterisation of the communication task.

Selecting a configuration in dependence upon a benchmarking process may include characterising the communication task; and on the basis of the characterisation, comparing the communication task with a list of communication tasks for which a benchmarking process has already been carried out and the results of said benchmarking process stored as a list, and, if it is determined that the communication task to be executed is sufficiently similar to a listed communication task, using the stored results for the selecting. The characterisation of a communication task may be done on the basis of a number of factors, including one or more of the following: message size, communication pattern (point-to-point or all-to-all), and communication primitive characteristics. For each factor (or characteristic), there may be a defined tolerance within which a communication task to be performed is deemed to be similar to a communication task for which stored results are available. If the defined tolerance is met for each characteristic then the stored results can be used for selecting a configuration for the communication task to be performed. Of course, if it is determined that the communication task to be executed is not sufficiently similar to a listed communication task, then the benchmarking process is performed.

Composing the benchmarking communication task itself may include assessing the amount of data to be transferred in the communication task, and multiplying that amount by a non-zero fraction that is less than one, so that the amount of data in the benchmark communication task is less than that in the communication task to be performed, but there is still some data to be communicated. The data may be sample data from a store of random data, or may be extracted from the communication task to be performed. Of course, other characteristics of the communication task to be performed may be maintained in composing the benchmark communication task, so that the benchmark communication task represents the communication task to be performed. For example, characteristics such as communication primitive (and some or all of the characteristics thereof), communication pattern (and possibly relative distances in terms of number of hops to one or more of the destination nodes), message type, message content (in terms of type of data) may be the same in the communication task to be performed and the corresponding benchmarking communication task.

Since the amount of data to be communicated is reduced in the benchmarking communication task, it may be that some extrapolation is required in order to predict how a configuration of communication engines and processing threads will perform when performing the communication task corresponding to the benchmarking communication task. Of course, since there are certain overheads associated with dividing up the task between communication engines and processing threads, the extrapolation may not be as simple as multiplying the time to perform the benchmarking communication task by the reciprocal of the fraction used to scale the amount of data in composing the benchmarking communication task. It may be that the extrapolation includes obtaining or deriving data transfer rates throughout the performance of the benchmarking communication task, and determining a data transfer rate representative of the rate at which additional data would be transferred, taking into account the fact that the overheads are fixed regardless of the amount of data. For example, it may be that peak data transfer rate is used, or an average data transfer rate once the first data have been communicated. That is to say, gathering the performance indicators includes gathering performance statistics for the performance of the benchmarking communication task by each of the candidate configurations, and extrapolating the performance statistics over the amount of data to be communicated in the communication task to obtain performance indicators.

Embodiments of the present invention may be configured so that selecting, in dependence upon a benchmarking process, a configuration of numbers of communication engines and processing threads per communication engine to allocate to executing said communication task, includes considering the performance impact on computation tasks of any potential configuration. For example, it may be that a metric used to assess candidate configurations that have performed a benchmarking processing task rewards the candidate configuration for completing the task quickly, and penalises the candidate configuration for each processing thread used, so that if using an additional processing thread does not have a sufficient performance benefit then the metric will be lower for that candidate configuration, and candidate configurations using fewer processing threads will be favoured. Of course, the design of a metric for scoring candidate configurations may be more complex and take into account many additional factors. Advantageously, such embodiments allow the configuration of communication engines and processing threads to be optimised for overall performance of an application, i.e., the overall distribution of the total number of threads between computation tasks and communication tasks is tuned (by the benchmarking process) to optimise performance of the application as a whole. An additional factor which may be considered in nominating and assessing candidate configurations is the value of idle threads. In a candidate configuration, some communication engines, processing threads, or processors may be left idle, and these idle resources may be afforded some value in the metric for scoring candidate configurations.

Embodiments of the present invention extend to a computing apparatus having a plurality of computing nodes arranged in an n-dimensional network, where n is an integer greater than or equal to 1, each computing node being configured to perform a plurality of processing threads simultaneously, and each computing node being connected to each of their neighbouring nodes via separate, and possibly parallel, data communication links, each computing node having a plurality of communication engines operable, simultaneously, and enlisting different combinations of data communication links from one another, to communicate a stream of data to one or more destination nodes; the computing apparatus comprising: a computing node from among the plurality of computing nodes configured to execute an application; including: a task detector configured to detect that a communication task including communicating data from the particular computing node to one or more destination computing nodes from among the plurality of computing nodes is to be executed; and a tuner configured to select, in dependence upon a benchmarking process, a configuration of communication engines and processing threads per communication engine to allocate to executing the detected communication task.

Embodiments of the present invention also include a computer program which, when executed by a computing apparatus having a plurality of computing nodes arranged in an n -dimensional network, where n is an integer greater than or equal to one, each computing node being configured to perform a plurality of processing threads simultaneously, and each computing node connected to each of their neighbouring nodes via separate data communication links, each computing node having a plurality of communication engines operable, simultaneously, and enlisting different combinations of data communication links from one another, to communicate a stream of data to one or more destination nodes, causes the computing apparatus to perform a method embodying the present invention.

Although the aspects (software/methods/apparatuses) are discussed separately, it should be understood that features and consequences thereof discussed in relation to one aspect are equally applicable to the other aspects. Therefore, where a method feature is discussed, it is taken for granted that the apparatus embodiments include a unit or apparatus configured to perform that feature or provide appropriate functionality, and that programs are configured to cause a computing apparatus on which they are being executed to perform said method feature.

In any of the above aspects, the various features may be implemented in hardware, or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

Preferred features of the present invention will now be described, purely by way of example, with reference to the accompanying drawings, in which:-
Figure 1 is a flowchart illustrating a process embodying the present invention;
Figure 2 illustrates the division of a communication task into sub-tasks for execution by multiple communication engines and multiple processing threads per communication engine;
Figure 3 is an illustration of a network topology and different communication paths between two nodes;
Figure 4 is a flow diagram of a method embodying the present invention; and
Figure 5 is a component diagram embodying the present invention.

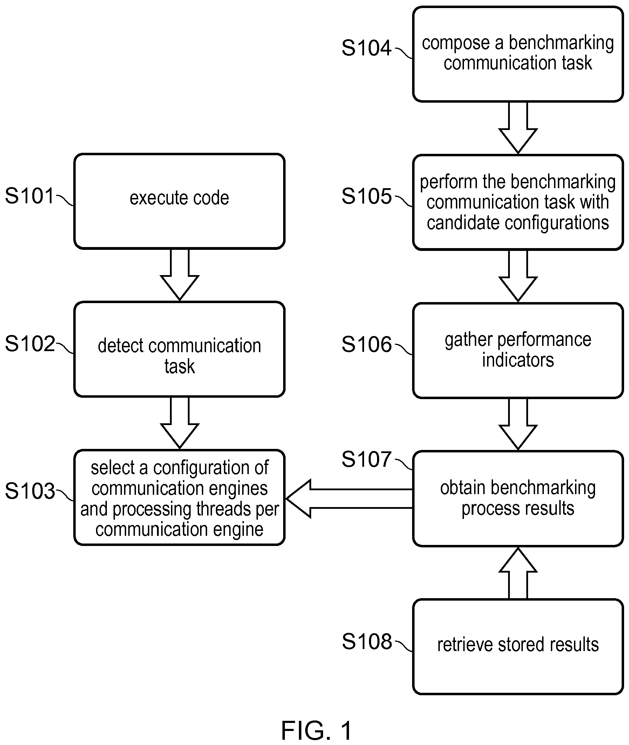

Figure 1 is a flowchart illustrating a process embodying the present invention. It should be understood that whilst Figure 1 is an illustration of a process, embodiments of the present invention include software and hardware arrangements configured to perform the described process. In general, it should be understood that features, options, and advantages discussed in relation to one aspect of invention embodiments are applicable to other aspects.

Steps S101 to S103 represent a method embodying the present invention. In addition, steps S104 to S107 represent a process which may be included as part of a method embodying the present invention. Steps S107 and S108 represent a process which may be included as part of a method embodying the present invention. The boxes represent individual steps in a process, and the arrows the logical progress of a process, and also perhaps a flow of information between one step and the next.

At step S101, code (as part of an application) is being executed. The computing node at which code is being executed may be referred to as a particular node, for convenience of reference, but there may not be any particular distinction of the computing node at which code is being executed in relation to the other nodes in the apparatus. The code may be being executed as part of a high performance computing application, and may be being executed in parallel with other code forming part of the same application. Executing code may include interpreting source code, machine code, or code in another format, and carrying out instructions contained therein, which may include computational tasks requiring processing and/or communication tasks including the transfer or communication of data from the particular node to other nodes in the apparatus.

At step S102, a communication task is detected. For example, the code may be marked up within the ParComm framework so that a ParComm pragma (#pragma ParComm) is included in the code to indicate the presence of a communication task. In general, a runtime library stored on or accessible to the particular node is used by a compiler to implement functions during execution of code. The detection of a communication task may be performed by a functional unit which could be defined as a task detector, which definition includes runtime library, or the combination of a runtime library and a processor, and other components which may be called upon in the interpretation and execution of source code.

The flow proceeds to S103, at which a configuration of communication engines and processing threads per communication engine is selected. Step S103 may be performed by a functional unit which could be referred to as a tuner, since it provides the functionality for a computing apparatus to tune the resources (which shall hereafter be used as a collective term to include at least communication engines and processing threads) at its disposal to the task to perform the detected task.

The selection of a configuration may be from a plurality of candidate configurations which may be different combinations of numbers of communication engines and processing threads per communication engine. For example, for a particular node having c communication engines, and a maximum of *p_{c}* processing threads per communication engine (which may depend on the number of communication engines in the particular configuration), it may be that the candidate configurations include every number of communication engines between 1 and c each combined with every number of processing threads between 1 and the *p_{c}* corresponding to that number of communication engines. That is to say, *p_{c}* may be larger for smaller numbers of communication engines and smaller for larger numbers of communication engines, due to the demands of parallel processing. There may be some form of filtering, so that certain configurations are ruled out as being unsuitable, for example, because they assign too high a portion of the node's resources to the task.

The selection of a configuration of communication engines and processing engines per thread is in dependence upon a benchmarking process, or more specifically, the results of a benchmarking process. The results of a benchmarking process may be a selection of an optimal configuration, so that the selecting step merely accepts the selection of the benchmarking process. Alternatively, the results of a benchmarking process may be performance indicators, including predictions of how each candidate configuration will behave in performing the task, wherein the predictions may include time taken and/or average or peak data transfer rates. At the particular node, a policy is applied to the performance indicators to generate a selection. For example, the policy may be to select the candidate configuration with the fastest predicted completion time for the task, or there may additional criteria, such as the fastest predicted completion time unless there is another candidate configuration which is less than a threshold time slower and uses fewer resources, in which case select the other configuration.

The benchmarking process may either be performed on demand as a task is detected, or may have been performed previously when a similar task was first detected and executed, and the results of the benchmarking process stored. In either case, the benchmarking process will have been performed at some stage. An exemplary benchmarking process is set out in steps S104 to S017.

At step S104 a benchmarking communication task is composed. The benchmarking communication task is based on the communication task to be performed. Hence, certain characteristics of the communication task to be performed are copied in composing the benchmarking communication task. For example, some or all of the message type, message communication pattern (point-to-point or all-to-all), message size, distance to destination node, and communication primitive characteristic may all be copied from the communication task to be performed into the benchmarking communication task. It may be that the amount of data is reduced in the benchmarking communication task compared to the communication task to be performed. For example, for a communication task having a number of messages, the number of messages could be reduced in the benchmarking communication task. Alternatively or additionally, the size (in terms of data) of the or each message could be reduced.

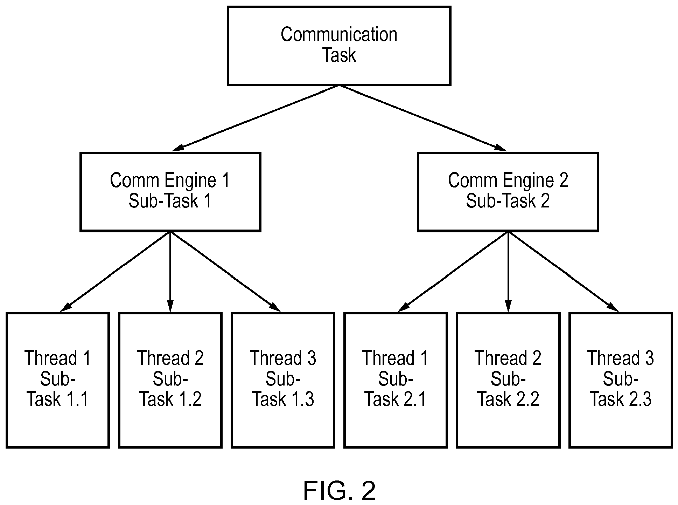

In step S105, the benchmarking communication task is performed with each of a plurality of candidate configurations. The derivation of the candidate configurations is discussed above. Figure 2 illustrates the hierarchical decomposition of a communication task (which could be a task being executed as part of the main application, or a benchmarking communication task) among communication engines and then among processing threads per communication engine. In the example of Figure 2, a communication task is divided into two simultaneous streams of data (Sub-Task 1 and Sub-Task 2) and is handled by two communication engines Comm Engine 1, and Comm Engine 2. Each communication engine further sub-divides its processing into separate simultaneous processing threads, each relating to a separate sub-task. The sub-tasks performed by these threads may be, for example, packing/unpacking buffers and sending/receiving data. Sub-Task 1 is assigned to Comm Engine 1 and is further sub-divided into Sub-Tasks 1.1, 1.2, and 1.3, performed by Thread 1a, Thread 2a, and Thread 3a, respectively. Sub-Task 2 is assigned to Comm Engine 2 and is further sub-divided into Sub-Tasks 2.1, 2.2, and 2.3, performed by Thread 1b, Thread 2b, and Thread 3b, respectively.

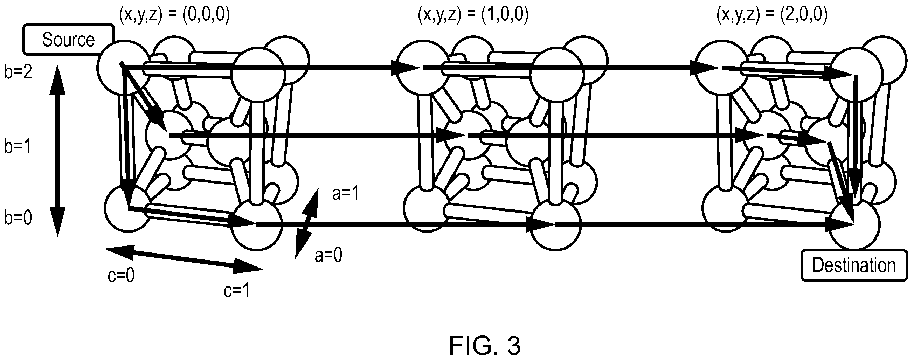

Figure 3 illustrates how multiple communication engines may each employ a different communication path (combination or series of communication links) in a network of nodes. The computing nodes are represented by balls in Figure 3, and communication links between neighbouring nodes by bars. The arrows represent the flow of data along communication links. In the example of Figure 3, a communication task is divided between three communication engines which each employ a different combination of communication links to transfer data from the source node to a destination node. The network architecture in Figure 3 is that of a six-dimensional torus, such as the Fujitsu Tofu architecture. More information on the Tofu interconnect is available at FUJITSU Sci. Tech. J., Vol. 48, No.3, pp. 280-285 (July 2012). In Figure 3, the communication paths are different for their entire length. This is optional, and will depend on the implementation details of the invention embodiment. Bottlenecks can be avoided by the use of completely separate communication paths by each communication engine. As another option, it may be that the communication engines of a particular node are configured to use different communication links (that is, communication links to different neighbouring nodes) for at least the first link along the path from source to destination.

By performing the benchmarking communication task with each of a number of different configurations of numbers of communication engines and processing threads per communication engine, the different configurations are trialled at runtime, and hence the best performing configuration can be selected. Wherein 'best' is determined by a policy, such as quickest.

At step S106, performance indicators are gathered. That is, a mechanism is in place for assessing the performance statistics of each of the configurations and turning these statistics into predictions for how that configuration will perform the task to be performed. For example, destination nodes may feedback to the particular node the time at which the complete message was received at the destination node. Alternatively or additionally, the rate at which data left the particular node may be measured by the I/O ports. These mechanisms provide performance statistics. Extrapolation of part of the statistics, in association with knowledge of the relationship between the communication task to be performed and the benchmarking communication task (for example, relative sizes), may be used to yield performance indicators. The extrapolation may not be as simple as reversing the reduction in data size from the communication task to be performed to the benchmarking communication task. For example, it may be that there is a period of time at the beginning, while the task is being split and pipelined, that no data is communicated. This time may be deemed to be fixed irrespective of data size, and hence the extrapolation is adapted to include a fixed time for splitting the task.

Step S107, obtaining benchmarking process results, may include simply making the performance indicators available for access by the process at step S103. Alternatively, it may be that S107 or S108 includes a step of applying a policy to the gathered performance indicators to determine a 'best' or 'optimal' configuration for the communication task to be performed. This may be as simple as selecting the configuration for which the performance indicators predict the quickest completion time of the communication task to be performed. Alternatively, where a number of factors are considered and reflected by performance indicators, a metric may be used to effectively weight the different factors to generate a score for each configuration, and select the configuration with the best (highest/lowest) score. A more complex policy may be applied which enables the configuration of threads and communication engines to be optimised for overall performance of the application. That is to say, the overall distribution of threads between computation tasks and communication tasks could be tuned to improve the overall (communication + computational) performance of the application. This could be incorporated into a policy by, for example, incorporating a 'cost' for each communication engine and thread used, so that if the performance benefit of using an additional communication engine or thread does not meet a threshold (the cost), then a configuration with fewer communication engines and/or threads becomes favourable, thus retaining resources for computational tasks.

When a communication task is detected as S102, it may be that a decision is made that a similar communication task has been executed in the past, and that a benchmarking process (steps S104 to S106 or S104 to S107) has been performed for such a task, and the results stored. At S108, the results of that past benchmarking process are retrieved, and used at S107 to feed into S103. Embodiments of the present invention may include a step of storing benchmarking process results in association with characteristics of the communication task to be performed in a list or database. The comparison of communication tasks to determine whether or not a similar task has been performed in the past may be based on characteristics including some or all of number of messages, (average) message size, communication pattern (point-to-point or all-to-all), (average) distances between nodes, communication primitive, total amount of data to be communicated etc. Tolerances may be applied in each case, so that two characteristics are deemed similar if the value of the characteristic of the task to be performed and the value of the characteristic of the task for which benchmarking process results are stored are the same to within the stated tolerance. It may be that some or all of the characteristics need to be deemed 'similar' for the results from the database or list to be used in preference to performing the process of steps S104 to S106. If the benchmarking process is performed (because no similar communication task is found in the list or database) then the results may be stored for retrieval when similar communication tasks are encountered in future.

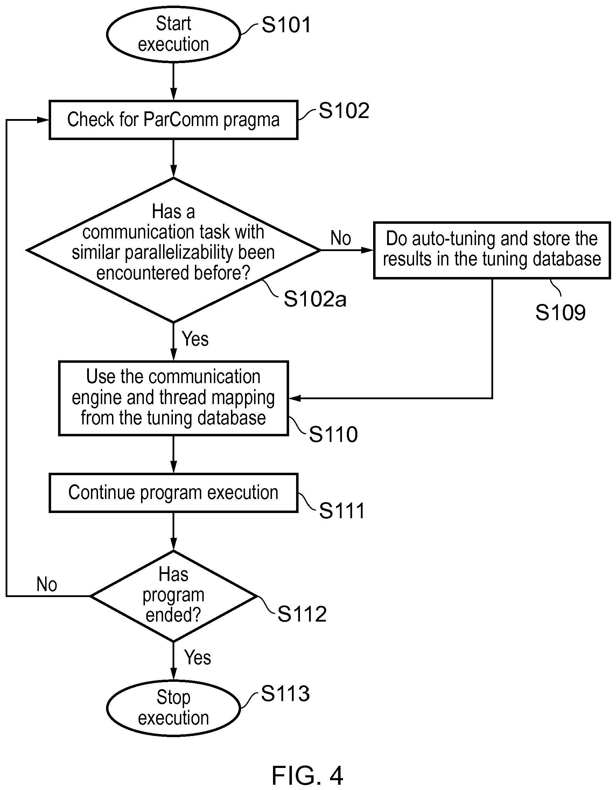

Figure 4 illustrates the flow of control in an embodiment of the present invention in which whenever a benchmarking process is performed, the results are recorded in a database in association with a characterisation of the communication task giving rise to the benchmarking process. Hence, when a communication task is detected at step S102, a decision is made at step S102a as to whether a similar task has been encountered before, and hence whether there are stored benchmarking process results which can be applied to the detected communication task.

The application or program being executed in Figure 4, or in other invention embodiments, may be a regular parallel application involving large message sizes or a large number of small messages as in an all-to-all communication, or an application involving hyper-dimensional communication patterns. The node or nodes executing the code are in networks of nodes having network topologies that involve multiple simultaneous communication links between the nodes. Each communication link in the network of nodes (the computing apparatus) may be driven by a separate communication engine, as in the Tofu topology. Using the methods set out in Figures 1 and 4, a configuration of communication engines and processing threads can be selected for each communication task in order to optimise the execution of that task.

In the example of Figure 4, the application being executed is one in which the source code is marked up with a ParComm pragma when there is a communication task to be executed, which eases the detection at step S102. The flow then proceeds to step S102a, at which it is determined whether a similar communication task has been encountered before, and hence whether or not it is necessary to perform a benchmarking process ('No' at S102a), or whether results from a previous benchmarking process can be used for the detected communication task ('Yes' at S012a). Specifically, characterisations of the communication tasks relevant to the extent to which the task lends itself to parallelisation are used to compare the detected communication task with those for which stored results are available.

We note that PacComm pragma is merely exemplary of parallel processing constructs or parallelisation directives, and that embodiments of the present invention could be implemented which utilise the syntaxes and associated functionalities of other parallel processing constructs or parallelisation directives.

ParComm #pragmas (or similar parallel processing constructs) are analogous to OpenMP #pragmas, and are used to mark communication tasks as candidates for parallelisation in code. Whenever a ParComm #pragma is encountered the runtime environment will know that the detected communication task can be distributed over one or more of the available communication engines on the node using one thread or a group of threads per communication engine, for example, as shown in Figure 3.

If no match is found, or no communication task for which stored results are available is deemed sufficiently similar to the detected task, the flow proceeds to step S109. Step S109 incorporates steps S104 to S107 from Figure 1, which are referred to as 'auto-tuning', and includes a step of storing a characterisation of the detected task along with the results of the benchmarking process, which in this example is an optimal configuration of communication engines and processing threads. The benchmarking process uses a benchmarking communication task which represents the detected communication task, and is run on the computing resources which will execute the detected communication task, so that the number of threads and communication engines selected to perform the detected task takes into account the network topology that is available for executing the application, for example, the optimal number of threads per communication engine will vary depending on whether a symmetric or asymmetric torus has been assigned to the job (executing the application).

The flow then proceeds to step S110, at which the results are retrieved from the database and used for selecting a configuration to perform the detected communication task. Similarly, if a match is found at step S102a, the flow proceeds to step S110 and the results from the match are used for selecting a configuration to perform the detected communication task.

Execution of the code continues at steps S111 and S112, until either the program has ended, S113, or another communication task is detected, in which case the flow returns to step S102.

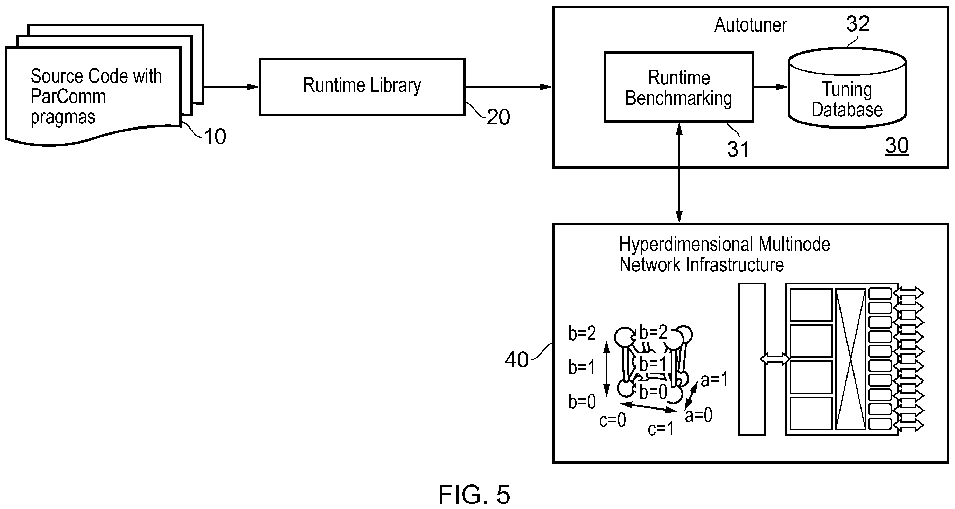

Figure 5 illustrates an exemplary component arrangement in an embodiment of the present invention. Of course, the components are not necessarily exclusively hardware or software, but may be functional components which include software and hardware to realise their respective functions.

The source code 10 is marked up with ParComm pragmas where communication tasks exist which can be parallelised. The runtime library 20 is used by a compiler to implement functions during execution, and runs on the node executing the application. When a ParComm pragma is encountered, such as in step S2, the runtime library (exemplary of a task detector) implements a function to refer to an autotuner 30 (exemplary of a tuner) to perform the check in S102a, to determine whether or not a similar or matching communication task has been encountered before, and specifically whether results of a benchmarking process for the similar or matching task are stored in a tuning database 32. If no match is found, then the runtime benchmarking process (such as steps S104 to S107) is carried out by functional unit 31 on the hyperdimensional multinode network infrastructure 40 (which is exemplary of a computing apparatus). The results of the runtime benchmarking process are recorded into the tuning database 32 for future reference.

The following example illustrates the use of a ParComm #pragma for the case where a new and previously unseen communication task is encountered by the runtime. The text is representative of processing carried out at runtime.

Example use of ParComm #pragma in the computation of a distributed, parallel 3D transform:
(i) 1D FFT in the Z dimension
(ii) 1D FFT in the Y dimension
(iii) Internal data rearrangement on each node
(iv) #pragma ParComm
(v) MPI_Alltoall(send_buffer,size,mpi_double_complex,...,recv_buffer,size,....)
(vi) 1D FFT in the X dimension
(vii) #pragma ParComm
(viii) MPI_Alltoall(send_buffer,size,mpi_double_complex,...,recv_buffer,size,....)
(ix) Internal data rearrangement on each node

The example uses an MPI (Message Passing Interface) communication primitive MPI_Alltoall to show the usefulness of the ParComm #pragmas included in source code in embodiments of the present invention. In methods embodying the present invention, when the ParComm #pragma is detected in (iv) (corresponding to S102), the runtime framework will try to parallelize the MPI_alltoall in (v). By trying out different combinations of (a) number of threads and (b) number of communication engines to be simultaneously used for the communication operation, the best performing combination of thread count and communication engine count is selected (corresponding to steps S104 to S107 and S103). This combination is then saved in a database managed by the run-time for future lookup (corresponding to S109). When the same MPI call with the ParComm #pragma is encountered in (vii) & (viii), the previously saved configuration will be used.

## Claims

1. A method for executing an application in a computing apparatus having a plurality of computing nodes arranged in an n-dimensional network (40), where n is an integer greater than or equal to one, each computing node being configured to perform a plurality of processing threads simultaneously, and each computing node being connected to each of their neighbouring nodes via separate data communication links, each computing node having a plurality of communication engines operable, simultaneously, and enlisting different combinations of data communication links from one another, to communicate a stream of data to one or more destination nodes; the method comprising:
executing (S101) the application at a particular computing node from among the plurality of computing nodes; including:
detecting (S102) that a communication task including communicating data from the particular computing node to one or more destination computing nodes from among the plurality of computing nodes is to be executed;
characterising the detected communication task based on characteristics comprising one or more from among: number of messages, message size, communication pattern, distances between nodes, communication primitive, and total amount of data to be communicated; and
selecting (S103) a configuration of numbers of communication engines and processing threads per communication engine to allocate to executing the detected communication task as an optimal configuration;
the selecting including:
on the basis of the characterisation of the detected communication task, comparing the communication task with a list of communication tasks for which a benchmarking process has already been carried out and the results of said benchmarking process stored, and, if it is determined that the detected communication task is sufficiently similar to a listed communication task, using the stored results for the selecting, and if it is determined that the communication task to be executed is not sufficiently similar to a listed communication task, performing a benchmarking process comprising:
composing (S104) a benchmarking communication task based on the detected communication task;
performing (S105) the benchmarking communication task using each of a plurality of candidate configurations of numbers of communication engines and processing threads per communication engine;
gathering (S106) performance indicators for each of the candidate configurations, by gathering performance statistics for the performance of the benchmarking communication task by each of the candidate configurations, and extrapolating the performance statistics over the amount of data to be communicated in the detected communication task to obtain performance indicators;
storing the gathered performance indicators in association with the characterisation of the detected communication task;
identifying, from among the candidate configurations, an optimal configuration for executing the communication task based on the gathered performance indicators, the identified optimal configuration being the selected optimal configuration; and
storing a representation of the optimal configuration in association with the characterisation of the detected communication task.

2. A method according to claim 1, wherein:
the amount of data to be communicated in the benchmarking communication task is a fraction between 0 and 1 of the amount of data to be communicated in the detected communication task.

3. A method according to any of the preceding claims, wherein
selecting, in dependence upon a benchmarking process, a configuration of numbers of communication engines and processing threads per communication engine to allocate to executing the detected communication task, includes considering the performance impact on computation tasks of any potential configuration.

4. A method according to claim 1, wherein selecting a configuration in dependence upon a benchmarking process includes applying a selection policy to the outcome of a benchmarking process to determine an optimal configuration to select.

5. A method according to any of the preceding claims, wherein
the different combinations of data communication links include at least different first data communication links from the computing node to one of its neighbouring nodes.

6. A computing apparatus having a plurality of computing nodes arranged in an n-dimensional network (40), where n is an integer greater than or equal to one, each computing node being configured to perform a plurality of processing threads simultaneously, and each computing node connected to each of their neighbouring nodes via separate data communication links, each computing node having a plurality of communication engines operable, simultaneously, and enlisting different combinations of data communication links from one another, to communicate a stream of data to one or more destination nodes; the computing apparatus comprising:
a computing node from among the plurality of computing nodes configured to execute an application; including:
a task detector configured to detect that a communication task including communicating data from the particular computing node to one or more destination computing nodes from among the plurality of computing nodes is to be executed;
the computing node being configured to:
characterise the detected communication task based on characteristics comprising one or more from among: number of messages, message size, communication pattern, distances between nodes, communication primitive, and total amount of data to be communicated; and
select a configuration of numbers of communication engines and processing threads per communication engine to allocate to executing the detected communication task as an optimal configuration;
the selecting including:
on the basis of the characterisation of the detected communication task, comparing the communication task with a list of communication tasks for which a benchmarking process has already been carried out and the results of said benchmarking process stored, and, if it is determined that the detected communication task is sufficiently similar to a listed communication task, using the stored results for the selecting, and if it is determined that the communication task to be executed is not sufficiently similar to a listed communication task, performing a benchmarking process;
the computing node further comprising:
a runtime benchmarking functional unit (31) configured to perform the benchmarking process, the benchmarking process comprising:
composing a benchmarking communication task based on the detected communication task;
performing the benchmarking communication task using each of a plurality of candidate configurations of numbers of communication engines and processing threads per communication engine;
gathering performance indicators for each of the candidate configurations by gathering performance statistics for the performance of the benchmarking communication task by each of the candidate configurations, and extrapolating the performance statistics over the amount of data to be communicated in the detected communication task to obtain performance indicators;
storing the gathered performance indicators in association with the characterisation of the detected communication task;
identifying, from among the candidate configurations, an optimal configuration for executing the communication task based on the gathered performance indicators, the identified optimal configuration being the selected optimal configuration; and
storing a representation of the optimal configuration in association with the characterisation of the detected communication task.

7. A computer program which, when executed by a computing apparatus having a plurality of computing nodes arranged in an n-dimensional network (40), where n is an integer greater than or equal to one, each computing node being configured to perform a plurality of processing threads simultaneously, and each computing node connected to each of their neighbouring nodes via separate data communication links, each computing node having a plurality of communication engines operable, simultaneously, and enlisting different combinations of data communication links from one another, to communicate a stream of data to one or more destination nodes, causes the computing apparatus to perform the method according to any of claims 1 to 5.

## Patentansprüche

1. Verfahren zum Ausführen einer Anwendung in einer Rechenvorrichtung mit einer Vielzahl von Rechenknoten, die in einem n-dimensionalen Netzwerk (40) angeordnet sind, wobei n eine ganze Zahl größer als oder gleich eins ist, jeder Rechenknoten konfiguriert ist, um eine Vielzahl von Verarbeitungs-Threads gleichzeitig durchzuführen, und jeder Rechenknoten über separate Datenkommunikationsverknüpfungen mit jedem seiner benachbarten Knoten verbunden ist, wobei jeder Rechenknoten eine Vielzahl von Kommunikations-Engines aufweist, die gleichzeitig betriebsfähig sind und voneinander verschiedene Kombinationen von Datenkommunikationsverknüpfungen auflisten, um einen Datenstrom an einen oder mehrere Zielknoten zu kommunizieren, wobei das Verfahren umfasst:
Ausführen (S101) der Anwendung an einem bestimmten Rechenknoten unter der Vielzahl der Rechenknoten; einschließlich:
Detektieren (S102), dass ein Kommunikations-Task ausgeführt werden soll, der Kommunizieren von Daten von dem bestimmten Rechenknoten an einen oder mehrere Zielrechenknoten unter der Vielzahl der Rechenknoten einschließt;
**dadurch gekennzeichnet, dass** der detektierte Kommunikations-Task auf Charakteristika basiert, die ein oder mehrere der folgenden umfassen: Anzahl der Nachrichten, Nachrichtgröße, Kommunikationsmuster, Abstände zwischen den Knoten, Kommunikationsstammfunktion und Gesamtmenge der zu kommunizierenden Daten; und
Auswählen (S103) einer Konfiguration von Anzahlen der Kommunikations-Engines und Verarbeitungs-Threads pro Kommunikations-Engine zur Zuweisung an die Ausführung des detektierten Kommunikations-Tasks als Optimalkonfiguration; wobei das Auswählen einschließt:
Vergleichen des Kommunikations-Tasks auf Grundlage der Charakterisierung des detektierten Kommunikations-Tasks mit einer Liste von Kommunikations-Tasks, für die bereits ein Benchmarking-Prozess durchgeführt wurde und die Ergebnisse des Benchmarking-Prozesses gespeichert wurden, und falls bestimmt wird, dass der detektierte Kommunikations-Task einem aufgelisteten Kommunikations-Task ausreichend ähnlich ist, Verwenden der gespeicherten Ergebnisse für das Auswählen, und falls bestimmt wird, dass der auszuführende Kommunikations-Task einem aufgelisteten Kommunikations-Task nicht ausreichend ähnlich ist, Durchführen eines Benchmarking-Prozesses, umfassend:
Zusammenstellen (S104) eines Benchmarking-Kommunikations-Tasks basierend auf dem detektierten Kommunikations-Task;
Durchführen (S105) des Benchmarking-Kommunikations-Tasks unter Verwendung von jeder von einer Vielzahl von Kandidatenkonfigurationen der Anzahlen von Kommunikations-Engines und Verarbeitungs-Threads pro Kommunikations-Engine;
Zusammentragen (S106) von Leistungsindikatoren für jede der Kandidatenkonfigurationen durch Zusammentragen von Leistungsstatistiken für die Leistung des Benchmarking-Kommunikations-Tasks durch jede der Kandidatenkonfigurationen, und Extrapolieren der Leistungsstatistiken über die in dem detektierten Kommunikations-Task zu kommunizierende Datenmenge, um Leistungsindikatoren zu erhalten;
Speichern der zusammengetragenen Leistungsindikatoren im Zusammenhang mit der Charakterisierung des detektierten Kommunikations-Tasks;
Identifizieren einer Optimalkonfiguration zum Ausführen des Kommunikations-Tasks unter den Kandidatenkonfigurationen basierend auf zusammengetragenen Leistungsindikatoren, wobei die identifizierte Optimalkonfiguration die ausgewählte Optimalkonfiguration ist; und
Speichern einer Repräsentation der Optimalkonfiguration im Zusammenhang mit der Charakterisierung des detektierten Kommunikations-Tasks.

2. Verfahren nach Anspruch 1, wobei:
die in dem Benchmarking-Kommunikations-Task zu kommunizierende Datenmenge eine Fraktion zwischen 0 und 1 von der in dem detektierten Kommunikations-Task zu kommunizierenden Datenmenge ist.

3. Verfahren nach einem der vorhergehenden Ansprüche, wobei
Auswählen einer Konfiguration von Anzahlen von Kommunikations-Engines und Verarbeitungs-Threads pro Kommunikations-Engine zur Zuweisung zur Ausführung des detektierten Kommunikations-Tasks in Abhängigkeit von einem Benchmarking-Prozess das Betrachten des Leistungseinflusses von jedweder potentiellen Konfiguration auf Rechen-Tasks einschließt.

4. Verfahren nach Anspruch 1, wobei das Auswählen einer Konfiguration in Abhängigkeit von einem Benchmarking-Prozess Anwenden einer Auswahlrichtlinie auf das Ergebnis eines Benchmarking-Prozesses einschließt, um eine Optimalkonfiguration für die Auswahl zu ermitteln.

5. Verfahren nach einem der vorhergehenden Ansprüche, wobei
die unterschiedlichen Kombinationen von Datenkommunikationsverknüpfungen mindestens unterschiedliche erste Datenkommunikationsverknüpfungen von dem Rechenknoten zu einem seiner benachbarten Knoten einschließen.

6. Rechenvorrichtung mit einer Vielzahl von Rechenknoten, die in einem n-dimensionalen Netzwerk (40) angeordnet sind, wobei n eine ganze Zahl größer als oder gleich eins ist, jeder Rechenknoten konfiguriert ist, um eine Vielzahl von Verarbeitungs-Threads gleichzeitig durchzuführen, und jeder Rechenknoten über separate Datenkommunikationsverknüpfungen mit jedem seiner benachbarten Knoten verbunden ist, wobei jeder Rechenknoten eine Vielzahl von Kommunikations-Engines aufweist, die gleichzeitig betriebsfähig sind und voneinander verschiedene Kombinationen von Datenkommunikationsverknüpfungen auflisten, um einen Datenstrom an einen oder mehrere Zielknoten zu kommunizieren, wobei die Rechenvorrichtung umfasst:
einen Rechenknoten unter der Vielzahl von Rechenknoten, der zum Ausführen einer Anwendung konfiguriert ist; und einschließt:
einen Task-Detektor, der zum Detektieren konfiguriert ist, dass ein Kommunikations-Task ausgeführt werden soll, der Kommunizieren von Daten von dem bestimmten Rechenknoten an einen oder mehrere Zielrechenknoten unter der Vielzahl der Rechenknoten einschließt;
wobei der Rechenknoten für folgendes konfiguriert ist:
Charakterisieren des detektierten Kommunikations-Tasks basierend auf Charakteristika, die ein oder mehrere der folgenden umfassen: Anzahl der Nachrichten, Nachrichtgröße, Kommunikationsmuster, Abstände zwischen Knoten, Kommunikationsstammfunktion und Gesamtmenge der zu kommunizierenden Daten; und
Auswählen einer Konfiguration von Anzahlen der Kommunikations-Engines und Verarbeitungs-Threads pro Kommunikations-Engine zur Zuweisung an die Ausführung des detektierten Kommunikations-Tasks als Optimalkonfiguration;
wobei das Auswählen einschließt:
Vergleichen des Kommunikations-Tasks auf Grundlage der Charakterisierung des detektierten Kommunikations-Tasks mit einer Liste von Kommunikations-Tasks, für die bereits ein Benchmarking-Prozess durchgeführt wurde und die Ergebnisse des Benchmarking-Prozesses gespeichert wurden, und falls bestimmt wird, dass der detektierte Kommunikations-Task einem aufgelisteten Kommunikations-Task ausreichend ähnlich ist, Verwenden der gespeicherten Ergebnisse für das Auswählen, und falls bestimmt wird, dass der auszuführende Kommunikations-Task einem aufgelisteten Kommunikations-Task nicht ausreichend ähnlich ist, Durchführen eines Benchmarking-Prozesses:
wobei der Rechenknoten ferner umfasst:
eine Laufzeit-Benchmarking-Funktionseinheit (31), die zum Durchführen des Benchmarking-Prozesses konfiguriert ist, wobei der Benchmarking-Prozess umfasst:
Zusammenstellen eines Benchmarking-Kommunikations-Tasks basierend auf dem detektierten Kommunikations-Task;
Durchführen des Benchmarking-Kommunikations-Tasks unter Verwendung von jeder von einer Vielzahl von Kandidatenkonfigurationen der Anzahlen von Kommunikations-Engines und Verarbeitungs-Threads pro Kommunikations-Engine;
Zusammentragen von Leistungsindikatoren für jede der Kandidatenkonfigurationen durch Zusammentragen von Leistungsstatistiken für die Leistung des Benchmarking-Kommunikations-Tasks durch jede der Kandidatenkonfigurationen, und Extrapolieren der Leistungsstatistiken über die in dem detektierten Kommunikations-Task zu kommunizierende Datenmenge, um Leistungsindikatoren zu erhalten;
Speichern der zusammengetragenen Leistungsindikatoren im Zusammenhang mit der Charakterisierung des detektierten Kommunikations-Tasks;
Identifizieren einer Optimalkonfiguration zum Ausführen des Kommunikations-Tasks unter den Kandidatenkonfigurationen basierend auf zusammengetragenen Leistungsindikatoren, wobei die identifizierte Optimalkonfiguration die ausgewählte Optimalkonfiguration ist; und
Speichern einer Repräsentation der Optimalkonfiguration im Zusammenhang mit der Charakterisierung des detektierten Kommunikations-Tasks.

7. Computerprogramm, das bei Ausführung auf einer Rechenvorrichtung mit einer Vielzahl von Rechenknoten, die in einem n-dimensionalen Netzwerk (40) angeordnet sind, wobei n eine ganze Zahl größer als oder gleich eins ist, wobei jeder Rechenknoten konfiguriert ist, um eine Vielzahl von Verarbeitungs-Threads gleichzeitig durchzuführen, und jeder Rechenknoten über separate Datenkommunikationsverknüpfungen mit jedem seiner benachbarten Knoten verbunden ist, wobei jeder Rechenknoten eine Vielzahl von Kommunikations-Engines aufweist, die gleichzeitig betriebsfähig sind und voneinander verschiedene Kombinationen von Datenkommunikationsverknüpfungen auflisten, um einen Datenstrom an einen oder mehrere Zielknoten zu kommunizieren, herbeiführt, dass die Computervorrichtung das Verfahren gemäß einem der Ansprüche 1 bis 5 durchführt.

## Revendications

1. Procédé pour exécuter une application dans un appareil de calcul comportant une pluralité de noeuds de calcul agencés dans un réseau à n dimensions (40), où n est un nombre entier supérieur ou égal à un, chaque noeud de calcul étant configuré pour effectuer une pluralité de fils de traitement simultanément, et chaque noeud de calcul étant relié à chacun de ses noeuds voisins via des liaisons de communication de données séparées, chaque noeud de calcul comprenant une pluralité de moteurs de communication pouvant fonctionner, simultanément, et mobilisant des combinaisons de liaisons de communication de données différentes les unes des autres, pour communiquer un flux de données à un ou plusieurs noeuds de destination ; le procédé comprenant les étapes consistant à :
exécuter (S101) l'application au niveau d'un noeud de calcul particulier parmi la pluralité de noeuds de calcul; comprenant les étapes consistant à :
détecter (S102) qu'une tâche de communication comprenant une communication de données à partir du noeud de calcul particulier à un ou plusieurs noeuds de calcul de destination parmi la pluralité de noeuds de calcul doit être exécutée ;
caractériser la tâche de communication détectée sur la base de caractéristiques comprenant une ou plusieurs parmi : le nombre de messages, la taille de message, un modèle de communication, des distances entre des noeuds, une primitive de communication, et une quantité totale de données à communiquer ; et
sélectionner (S103) une configuration de nombres de moteurs de communication et de fils de traitement par moteur de communication à attribuer pour exécuter la tâche de communication détectée comme une configuration optimale ; la sélection comprenant :
sur la base de la caractérisation de la tâche de communication détectée, la comparaison de la tâche de communication avec une liste de tâches de communication pour lesquelles un processus d'analyse comparative a déjà été effectué et les résultats dudit processus d'analyse comparative stockés, et, s'il est déterminé que la tâche de communication détectée est suffisamment similaire à une tâche de communication listée, utiliser les résultats stockés pour la sélection, et s'il est déterminé que la tâche de communication à exécuter n'est pas suffisamment semblable à une tâche de communication listée, exécuter un processus d'analyse comparative comprenant les étapes consistant à :
composer (S104) une tâche de communication d'analyse comparative sur la base de la tâche de communication détectée ;
exécuter (S105) la tâche de communication d'analyse comparative en utilisant chacune d'une pluralité de configurations candidates de nombres de moteurs de communication et de fils de traitement par moteur de communication ;
rassembler (S106) des indicateurs de performance pour chacune des configurations candidates, en rassemblant des statistiques de performance pour l'exécution de la tâche de communication d'analyse comparative par chacune des configurations candidates, et en extrapolant les statistiques de performance sur la quantité de données à communiquer dans la tâche de communication détectée pour obtenir des indicateurs de performance ;
stocker les indicateurs de performance rassemblés en association avec la caractérisation de la tâche de communication détectée ;
identifier, parmi les configurations candidates, une configuration optimale pour l'exécution de la tâche de communication sur la base des indicateurs de performance rassemblés, la configuration optimale identifiée étant la configuration optimale sélectionnée ; et
stocker une représentation de la configuration optimale en liaison avec la caractérisation de la tâche de communication détectée.

2. Procédé selon la revendication 1, dans lequel :
la quantité de données à communiquer dans la tâche de communication d'analyse comparative est une fraction entre 0 et 1 de la quantité de données à communiquer dans la tâche de communication détectée.

3. Procédé selon l'une quelconque des revendications précédentes, dans lequel
la sélection, en fonction d'un processus d'analyse comparative, d'une configuration de nombres de moteurs de communication et de fils de traitement par moteur de communication à attribuer pour exécuter la tâche de communication détectée, comprend la prise en considération de l'impact de performance sur des tâches de calcul de toute configuration potentielle.

4. Procédé selon la revendication 1, dans lequel la sélection d'une configuration en fonction d'un processus d'analyse comparative comprend l'application d'une politique de sélection à l'issue d'un processus d'analyse comparative pour déterminer une configuration optimale à sélectionner.

5. Procédé selon l'une quelconque des revendications précédentes, dans lequel
les différentes combinaisons de liaisons de communication de données comprennent au moins des premières liaisons de communication de données différentes à partir du noeud de calcul vers l'un de ses noeuds voisins.

6. Appareil de calcul comportant une pluralité de noeuds de calcul agencés dans un réseau à n dimensions (40), où n est un nombre entier supérieur ou égal à un, chaque noeud de calcul étant configuré pour exécuter une pluralité de fils de traitement simultanément, et chaque noeud de calcul étant relié à chacun de ses noeuds voisins via des liaisons de communication de données séparées, chaque noeud de calcul ayant une pluralité de moteurs de communication pouvant fonctionner, simultanément, et mobilisant des combinaisons de liaisons de communication de données différentes les unes des autres, pour communiquer un flux de données vers un ou plusieurs noeuds de destination ; l'appareil de calcul comprenant :
un noeud de calcul parmi la pluralité de noeuds de calcul configuré pour exécuter une application ; comprenant :
un détecteur de tâche configuré pour détecter qu'une tâche de communication comprenant une communication de données à partir du noeud de calcul particulier vers un ou plusieurs noeuds de calcul de destination parmi la pluralité de noeuds de calcul est à exécuter ;
le noeud de calcul étant configuré pour :
caractériser la tâche de communication détectée sur la base de caractéristiques comprenant une ou plusieurs parmi : le nombre de messages, la taille de message, un modèle de communication, des distances entre des noeuds, une primitive de communication, et une quantité totale de données à communiquer ; et
sélectionner une configuration de nombres de moteurs de communication et de fils de traitement par moteur de communication à attribuer pour exécuter la tâche de communication détectée comme une configuration optimale ;
la sélection comprenant :
sur la base de la caractérisation de la tâche de communication détectée, la comparaison de la tâche de communication avec une liste de tâches de communication pour lesquelles un processus d'analyse comparative a déjà été effectué et les résultats dudit processus d'analyse comparative stockés, et, s'il est déterminé que la tâche de communication détectée est suffisamment similaire à une tâche de communication listée, utiliser les résultats stockés pour la sélection, et s'il est déterminé que la tâche de communication à exécuter n'est pas suffisamment semblable à une tâche de communication listée, exécuter un processus d'analyse comparative ;
le noeud de calcul supplémentaire comprenant :
une unité fonctionnelle d'analyse comparative d'exécution (31) configurée pour effectuer le processus d'analyse comparative, le processus d'analyse comparative comprenant les étapes consistant à :
composer une tâche de communication d'analyse comparative sur la base de la tâche de communication détectée ;
exécuter la tâche de communication d'analyse comparative en utilisant chacune d'une pluralité de configurations candidates de nombres de moteurs de communication et de fils de traitement par moteur de communication ;
rassembler des indicateurs de performance pour chacune des configurations candidates, en rassemblant des statistiques de performance pour l'exécution de la tâche de communication d'analyse comparative par chacune des configurations candidates, et en extrapolant les statistiques de performance sur la quantité de données à communiquer dans la tâche de communication détectée pour obtenir des indicateurs de performance ;
stocker les indicateurs de performance rassemblés en association avec la caractérisation de la tâche de communication détectée ;
identifier, parmi les configurations candidates, une configuration optimale pour l'exécution de la tâche de communication sur la base des indicateurs de performance rassemblés, la configuration optimale identifiée étant la configuration optimale sélectionnée ; et
stocker une représentation de la configuration optimale en liaison avec la caractérisation de la tâche de communication détectée.

7. Programme informatique qui, lorsqu'il est exécuté par appareil de calcul ayant une pluralité de noeuds de calcul agencés dans un réseau à n dimensions (40), où n est un nombre entier supérieur ou égal à un, chaque noeud de calcul étant configuré pour exécuter une pluralité de fils de traitement simultanément, et chaque noeud de calcul étant connecté à chacun de ses noeuds voisins via des liaisons de communication de données séparées, chaque noeud de calcul comprenant une pluralité de moteurs de communication pouvant fonctionner, simultanément, et mobilisant des combinaisons de liaisons de communication de données différentes les unes des autres, pour communiquer un flux de données vers un ou plusieurs noeuds de destination, amène l'appareil de calcul à exécuter le procédé selon l'une quelconque des revendications 1 à 5.
